# EUROPEAN PATENT APPLICATION

(11) **EP 1 227 528 A2**
(43) Date of publication of application: **31.07.2002**
(21) Application number: 02075121.0
(22) Date of filing: 14.01.2002
(51) Int. Cl.: H01L 51/20

(54) **Organic light emitting devices having a modified electron-transport layer**

(30) Priority: 26.01.2001 US 770126
(71) Applicant: EASTMAN KODAK COMPANY, Rochester, New York 14650 (US)
(72) Inventor: Raychaudhuri, Pranab Kumar, Rochester, New York 14650-2201 (US); Tang, Ching W., Rochester, New York 14650-2201 (US); Madathil, Joseph Kuru, Rochester, New York 14650-2201 (US); Comfort, Dustin, Rochester, New York 14650-2201 (US)
(74) Representative: Nunney, Ronald Frederick Adolphe

(57) **Abstract**

An OLED device including a substrate, an anode formed of a conductive material over the substrate, and an emissive layer having an electroluminescent material provided over the anode. The OLED device also includes an electron- transport layer containing lithium metal provided over the emissive layer and a cathode layer provided on the electron transport layer such cathode layer being formed of a material which can work as an efficient electron injecting contact without the modification of electron transport layer and having a function between about 2.0 and about 4.0 V.

## Description

The present invention relates to organic light-emitting diode devices and methods for making such devices, which use a modified electron transport layer.

Organic electroluminescent (OEL) device, alternately known as organic light-emitting diode (OLED), is useful in flat-panel display applications. This light-emissive device is attractive because it can be designed to produce red, green, and blue colors with high luminance efficiency; operable with a low driving voltage of the order of a few volts and viewable from oblique angles. These unique attributes are derived from a basic OLED structure comprising of a multilayer stack of thin films of small-molecule organic materials sandwiched between an anode and a cathode. Tang and others in commonly-assigned US-A-4,769,292 and US-A-4,885,211 have disclosed such a structure. The common electroluminescent ( EL) medium is comprised of a bi-layer structure of a hole-transport (HTL) layer and an electron-transport layer (ETL), typically of the order of a few tens of nanometer thick for each layer. The anode material is usually an optically transparent indium tin oxide (ITO) glass, which also serves as the substrate for the OLED. The cathode is typically a reflective thin film. The device emits visible light in response to a potential difference applied across the EL medium. When an electrical potential difference is applied at the electrodes the injected carriers- hole at the anode and electron at the cathode -migrate towards each other through EL medium and a fraction of them recombine to emit light. To increase the efficiency of electroluminesence it is necessary to decrease the barrier to charge injection at the electrodes and achieve a right balance between the supply of holes and electrons at the emitting zone. Selection of electrode materials is based on work functions. ITO is most commonly used as the anode because it is transparent and has a high work function. Mg:Ag alloys are generally used as an electron injecting contacts because they have lower work functions. Lithium containing alloys such as Al:Li, Ag:Li and LiF/Al contacts also provide efficient electron injection. It is believed that lithium from these contacts diffuses in the electron transport layer and lowers the electron injection barrier. Junji Kido and Toshio Matsumoto, in their publication"Bright oganic electroluminescent devices having a metal-doped electron-injecting layer" (Appl. Phys. Letts. 73, 2866, 1998), disclosed a method of making another efficient electron injecting contact. These authors doped the surface layer of Alq with low work function and reactive metals. The doped layers were made by coevaporation of metal and pure Alq from separate sources. When an overlayer of Al was provided over a Li doped Alq surface, the resultant device showed excellent performance. By comparison, Al cathode on pure Alq surface made the device highly ineffecient. Their data show that for a 5 nm thick Li doped Alq device at 20 mA/cm² drive current the operating voltage and efficiency are about 7 V and 3.0 cd/A, respectively. By comparison a device using undoped Alq, and otherwise identical in structure, exhibits under identical conditions an operating voltage of about 10.5 V and an efficiency of 1.0 cd/A, respectively. It is already well known that Al is not useable as a cathode on Alq as it makes inefficient devices. The Li doping permits the use of Al. The reference only provides improved results relative only to Al as cathode material.

It is therefore an object of the present invention to provide a novel OLED device structure, which exhibits high performance.

This object is achieved in an OLED device, comprising:
a) a substrate;
b) an anode formed of a conductive material over the substrate;
c) an emissive layer having an electroluminescent material provided over the anode layer;
d) an electron transport layer provided over the emissive layer and containing Li metal; and
e) a cathode layer provided on the electron transport layer such cathode layer being formed of a material which can work as an efficient electron injecting contact without the modification of electron transport layer and having a function between about 2.0 and about 4.0 V.

An advantage of the present invention is that the OLED device of the present invention is operable with a lower drive voltage compared to devices having an electron-transport layer without Li but otherwise similar in structure.

Another advantage of the present invention is that OLED devices of the present invention have higher luminance compared to the device having an electron-transport layer without Li but otherwise similar in structure.
FIG. 1 shows schematically the layer structure of an OLED device;
FIG. 2 is a graph of luminance and voltage versus pure Alq thickness for the device of FIG. 1;
FIG. 3 is a graph of luminance and voltage versus total Alq thickness for a partially Li containing Alq layer wherein the pure Alq portion is 5 nm;
FIG. 4 is a graph of luminance and voltage versus total Alq thickness for a partially Li containing Alq layer wherein the pure Alq portion is 10 nm;
FIG. 5 is a graph of luminance and voltage versus total Alq thickness for a partially Li containing Alq layer wherein the pure Alq portion is 20 nm;
FIG. 6 is a graph of luminance and voltage versus total Alq thickness for a partially Li containing Alq layer wherein the pure Alq portion is 30 nm;
FIG. 7 is a graph of luminance and voltage for a fixed total Alq thickness of 60 nm but varying the thickness of the pure Alq portion of the total Alq layer; and
FIG. 8 is a graph similar to FIG. 7 of luminance and voltage for a fixed total Alq thickness of 60 nm but varying the thickness in a greater range of the pure Alq portion of the total Alq layer.

Throughout the ensuring description acronyms are used to designate the names of different layers and operating features of organic light-emitting diode devices. For reference, they are listed in Table 1.

**TABLE 1**

| | |
|---|---|
| OLED | Organic light emitting diode |
| ITO | Indium tin oxide |
| HIL | Hole injection layer |
| HTL | Hole transport layer |
| EML | Emissive layer |
| ETL | Electron transport layer |
| NPB | 4,4'-Bis[N-(1-naphthyl)-N-phenylamino]biphenyl (NPB) |
| Alq | Tris(8-hydroxyquinoline) aluminum |
| Mg:Ag | Magnesium -silver alloy |

Returning to the Kido and others reference it does not suggest or discuss the benefit of Li doping when electron injecting electrodes having a work function less than 4.0 V are used. From their study there is no suggestion that Li doping can further improve the performances of such devices. This is an important discovery in accordance with the present invention. Kido and others made a device having an Al electrode on 5 nm thick Li doped Alq surface layer and their data show an efficiency of 3.0 cd/A, and an operating voltage of 7.2 V at 20 mA/cm² drive current. The present invention in one embodiment uses a MgAg cathode (work function of Mg is about 3.6 V) on pure Alq surface that also gives rise to device performances of 3.0 cd/A and 6.6 V operating voltage at 20 mA/cm² drive current. In Kido and others investigation they varied Li doped layer keeping the total thickness of Alq layer constant at 70nm., and produced data that shows that device efficiency progressively dropped with increasing Li doped layer. For example, at a driving voltage of 9 V the device efficiencies for 5nm, 30 nm and 60nm Li doped layers were 4.3 cd/A, 3.9 cd/A and 2.9 cd/A, respectively. It is believed that these results are due to luminescence quenching. Kido and others data show that photoluminescence is quenched by Li doping of Alq. They investigated other dopant metals and found that Sr and Sm were not as effective as Li even though their work functions are lower than that of Li. No clear explanation was given, but Kido and others postulated that the large atomic sizes of Sr and Sm might have prevented them from reacting with nonplanar Alq molecule. They preferred bathophenanthroline (Bphen) to Alq as a host material. Bphen is known to form complexes with metal ions. Sr and Sm doped Bphen devices exhibited improved performance compared with devices with Alq as host. Furthermore, they believed that Li migration might also cause performance degradation of Alq devices. While Li doping of Alq surface was shown by Kido and others as a way to use Al, (a high work function metal) as an efficient electron injecting layer, the work of Kido and others teaches away from extensive bulk doping of pure Alq. During experimentation with Li doping for a cathode sputtering work, it has been quite unexpectedly found that by mixing Alq with Li the performance of the devices can be significantly improved. It was discovered that by spatially modifying the Alq with Li the luminance was enhanced, without degrading the operational stability of device.

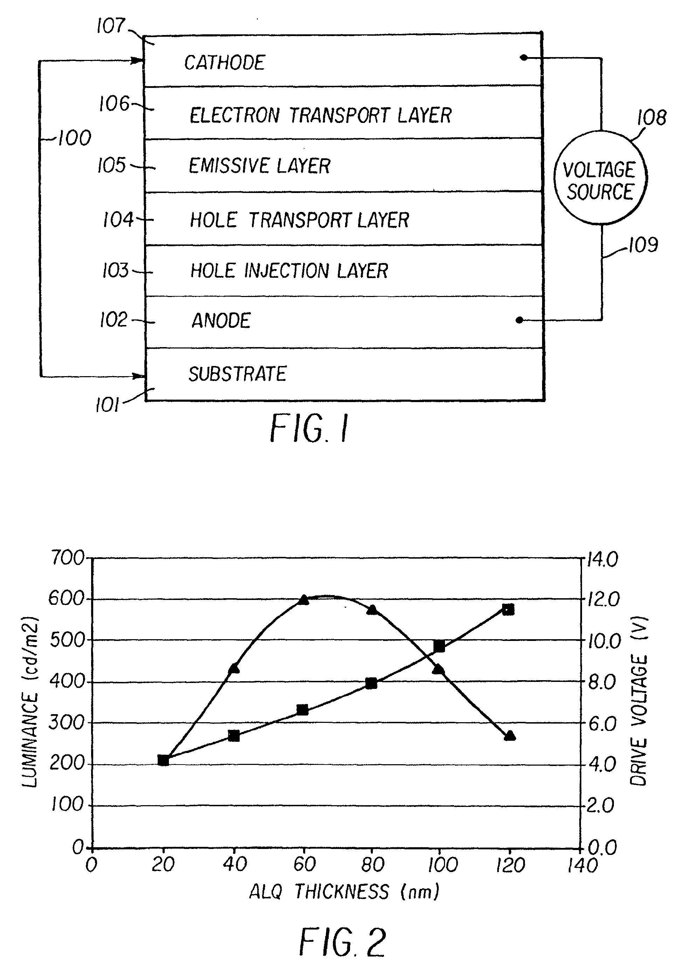

Turning now to FIG. 1, the OLED device 100 of this invention includes a substrate 101, an anode 102, a hole injection layer (HIL) 103, a hole transport layer (HTL) 104, an emissive layer (EML) 105, an electron transport layer (ETL) 106, and a cathode 107. In operation, the anode 102 and the cathode 107 are connected to a voltage source 108 via conductors 109 and electrical current is passed through the organic layers, resulting in light emission or electroluminescence from the OLED device 100. Depending on the optical transparency of the anode 102 and cathode 107, electroluminescence can be viewed from either the anode side or the cathode side. The intensity of the electroluminescence is dependent on the magnitude of the electrical current that is passed through the OLED device 100, which in term is dependent on the luminescent and electrical characteristics of the organic layers as well as the charge injecting nature of the anode 102 and cathode 107.

The composition and the function of the various layers constituting the OLED device 100 are described as follows:

Substrate 101 can include glass, ceramic, or plastics. Since the OLED device 100 fabrication does not require high temperature process, any substrate 101 that can withstand process temperatures of the order of 100°C is useful, which includes most thermal plastics. The substrate 101 can take the form of rigid plate, flexible sheet, or curved surfaces. Substrate 101 can include support with electronic backplane, and thus includes active-matrix substrates, which contain electronic addressing and switching elements. Examples of such active-matrix substrates include single-crystal silicon wafer with CMOS circuit elements. Other examples include substrates with high-temperature polysilicon thin-film-transistors, substrates with low-temperature polysilicon thin-film-transistors, substrates with amorphous silicon transistors, or any substrates with thin-film transistor. Those skilled in the art will appreciate that other circuit elements can be used to address and drive the OLED devices.

Anode 102 provides the function of injecting hole into the organic layer when a positive potential relative to the cathode 107 is applied to the OLED device 100. It has been shown, for example in commonly-assigned U.S. Patent 4,720,432, that indium tin oxide (ITO) forms excellent anode because it has a relatively high work function. Since ITO film itself is transparent, ITO coated glass provides an excellent support for the fabrication of OLED devices. Other suitable anode materials include high work function metals such as Au, Pt, Pd, or alloys of these metals.

Hole-injection layer (HIL) 103 provides the function of increasing the efficiency of the hole injection from the anode 102 into the organic layers. It has been shown, for example in commonly-assigned U.S. Patent 4,885,211, that a porphorinic or phthalocyanine compound is useful as a hole injection layer 103, resulting in increased luminance efficiency and operational stability. Other preferred HIL materials include CFx, which is a fluorinated polymer deposited by plasma-assisted vapor deposition, wherein x is less than or equal to 2 and greater than 0. The method of preparation and the characteristics of CFx have been disclosed in commonly assigned U.S. Patent Application No. 09/186,538, filed November 5, 1998, entitled "Organic Electroluminescent Device With a NonConductive Flurocarbon Polymer" by Hung and others, the disclosure of which is incorporated herein.

Hole -transport layer (HTL) 104 provides the function of transporting holes to the emissive layer (EML) 105. HTL materials include various classes of aromatic amines as disclosed in commonly assigned U.S. Patent 4,720,432. A preferred class of HTL materials includes the tetraaryldiamines of formula (I). 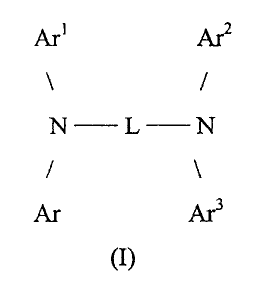 wherein:
Ar, Ar¹, Ar² and Ar³ are independently selected from among phenyl, biphenyl and naphthyl moieties;
L is a divalent naphthylene moiety or dₙ
d is a phenylene moiety;
n is an integer of from 1 to 4; and
at least one of Ar, Ar¹, Ar² and Ar³ is a naphthyl moiety.

Illustrative of useful selected (fused aromatic ring containing) aromatic tertiary amines are the following:
4,4'-Bis[N-(1-naphthyl)-N-phenylamino]biphenyl (NPB)
4,4"-Bis[N-(1-naphthyl)-N-phenylamino]-p-terphenyl
4,4'-Bis[N-(2-naphthyl)-N-phenylamino]biphenyl
1,5-Bis[N-(1-naphthyl)-N-phenylamino]naphthalene
4,4'-Bis[N-(2-pyrenyl)-N-phenylamino]bi-phenyl
4,4'-Bis[N-(2-perylenyl)-N-phenylamino]biphenyl
2,6-Bis(di-p-tolylamino)naphthalene
2,6-Bis[di-(1-naphtyl)amino]naphthalene

Emissive layer 105 of FIG. 1 provides the function of light emission produced as a result of recombination of holes and electrons in this layer. A preferred embodiment of the emissive layer 105 includes a host material doped with one or more fluorescent dyes. The emissive layer 105 should have a thickness greater than 5nm but less than 40 nm. These dyes can include one or more of the following green, red or blue light emitting materials, which are well known in the art. Using this host-dopant composition, highly efficient OLED devices can be constructed. Simultaneously, the color of the EL devices can be tuned by using fluorescent dyes of different emission wavelengths in a common host material. Tang and others in commonly assigned US-A-4,769,292 has described this dopant scheme in considerable details for OLED devices using Alq as the host material. As set forth in the Tang and others US-A-4,769,292, the emissive layer can contain a green light-emitting doped material, a blue light-emitting doped material, or a red light- emitting doped material.

Preferred host materials include the class of 8-quinolinol metal chelate compounds with the chelating metals being Al, Mg, Li, Zn, for example. Another preferred class of host materials includes anthracene derivatives such as 9,10 dinaphthyl anthracene; 9,10 dianthryl anthracene; alkyl substituted 9,10 dinaphthyl anthracene, as disclosed in commonly-assigned US-A-5,935,721

Dopant materials include most fluorescent and phorphorescent dyes and pigments. Preferred dopant materials include coumarins such as Coumarin 6, dicyanomethylenepyrans such as 4-dicyanomethylene-4H pyrans, as disclosed in commonly-assigned US-A-4,769,292 and commonly-assigned US-A-6,020,078.

Electron transport layer 106 of FIG. 1 provides the function of delivering electrons injected from the cathode to the emissive layer 105. Useful materials include Alq, benzazoles, and other materials as disclosed in commonly-assigned US-A-5,645,948.

Cathode (107) of FIG. 1 provides the function of injecting electron into the OLED organic layers. Commonly used cathode materials include alloys of MgAg (C.W. Tang and S.A. VanSlyke, Appl. Phys. Lett. 51, 913 (1987)), LiF/Al bilayer, or Li alloys. The MgAg cathodes are usually deposited by simultaneous deposition of Mg and Ag in high vacuum. LiF/ Al cathodes are fabricated by sequential evaporation of LiF and Al. Li doping of Alq surface layers can also provide efficient electron injection. Li containing cathodes can also be deposited by evaporation or sputtering.

Although the FIG. 1 embodiment is believed preferred, it will be appreciated by those skilled in the art that a device can also be made which does not use hole injection layer 103, hole transport layer 104 and electron-transport layer 106. Those skilled in the art will appreciate that the emissive layer can be selected to include hole transport and electron-transport functions and the anode layer can function as the hole- injection layer. In such an instance, the device requires 105 and does not require layers 103, 104, and 106.

### EXAMPLES

In the following examples, reference should be made to Table 1 for the appropriate functions of layers corresponding to the listed acronym. The substrates used were ITO coated glass upon which the layers comprising the OLEDs were deposited. In Tables 2 through 8 presented are the structure, layer thickness and performance of the devices. Instead of tabulating the thicknesses of the emissive and the electron-transport layes, given in tables are the thickness of pure Alq layer and that of lithium mixed Alq, hereafter Alq:Li, layer. The term "pure Alq" refers to the fact although there maybe some other insubstantial or trace amounts of contaminant material the intent was to just have Alq. Prior to the present invention, it was not known how lithium mixing would affect the location of emitting zone. The pure Alq layer was placed adjacent to the hole-transport layer and Alq:Li was deposited adjacent to the cathode. The pure Alq layer may additionally contains green, blue and red light-emitting dopants. The concentration of Li in Alq:Li layer can be from 1 to 5% by volume. In these tables L (cd /m²) refers to the luminance of the device when a current corresponding to 20 mA / cm² is driven through the device and V (volt) refers to the drive voltage under this condition after accounting for ITO resistance.

### Example 1

In Table 2 shown are the data for a set of devices each employing only pure Alq. The thickness of pure Alq was varied keeping all other layers constant. The performance is also plotted in FIG 2. It is clearly seen from Table 2 and FIG. 2 that the luminance initially increases with pure Alq thickness, maximizes around 65nm, and then decreases with increasing pure Alq thickness. The increase in driving voltage with pure Alq thickness, however, is monotonic and nearly linear with about 70 mV rise per nm. The luminance of the device 203 with 60 nm pure Alq is 592 cd /m² which is the maximum value in this thickness series. The device efficiency is 3 cd/A and the driving voltage is 6.6 V. Thus, it is clear from Table 2 and FIG. 2 that the luminance is maximized at the pure Alq thickness of about 65 nm.

**Table 2.**

| Structure, Layer Thickness and Performance of OLED Devices with Varying Thickness of Pure Alq Layer | | | | | | | | |
|---|---|---|---|---|---|---|---|---|
| Device ID | Anode ITO thickness (nm) | HIL CFx thickness (nm) | HTL NPB thickness (nm) | Pure Alq thickness (nm) | Alq :Li thickness (nm) | Cathode Mg:Ag thickness (nm) | Luminance (Cd/m²) | Drive voltage (V) |
| 201 | 42 | 1 | 150 | 20 | 0 | 110 | 206 | 4.2 |
| 202 | 42 | 1 | 150 | 40 | 0 | 110 | 432 | 5.4 |
| 203 | 42 | 1 | 150 | 60 | 0 | 110 | 592 | 6.6 |
| 204 | 42 | 1 | 150 | 80 | 0 | 110 | 570 | 7.9 |
| 205 | 42 | 1 | 150 | 100 | 0 | 110 | 426 | 9.7 |
| 206 | 42 | 1 | 150 | 120 | 0 | 110 | 268 | 11.5 |

### Example 2

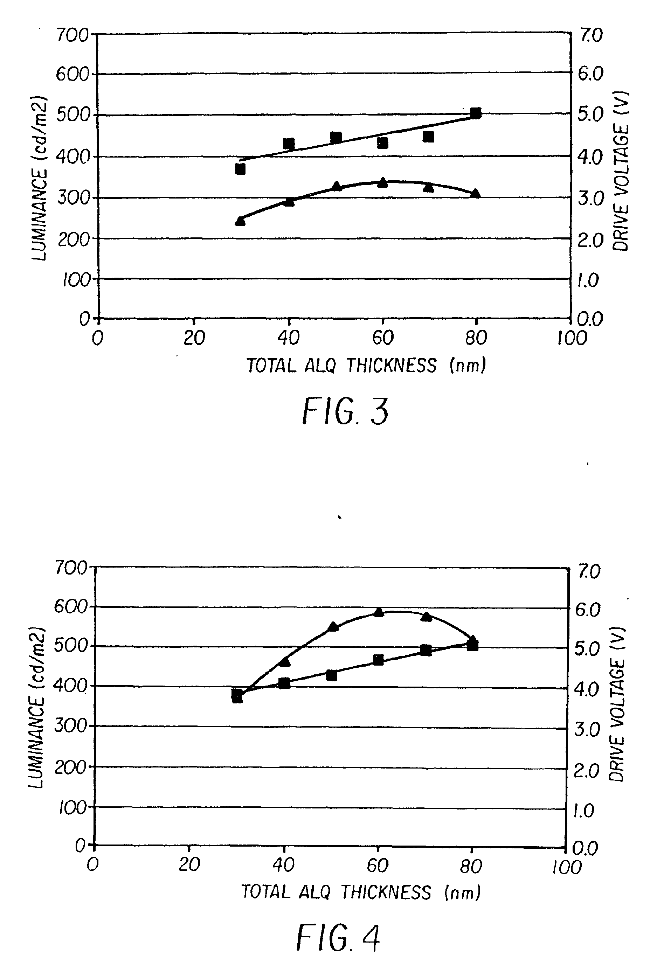

In Table 3 shown are the data for a set of devices that employ both pure Alq and Alq:Li. The thickness of the pure Alq layer was fixed at 5 nm and that of the Alq:Li. layer was varied. The performance is also plotted in FIG. 3 as a function of sum of the thicknesses of pure Alq and Alq:Li layers, hereafter total Alq. It is clearly seen that the luminance initially increases with the total Alq thickness, maximizes around 60nm, and then decreases with increasing thickness. However, in comparison with the thickness series of Table 2 the rise and fall of luminance with total Alq thickness is very gradual. The increase in driving voltage with total Alq thickness, though again monotonic, is gentler than that in the series of Table 2. The rise in drive voltage is about 30 mV per nm. The gentle slope of the voltage versus total Alq thickness plot is due to Alq:Li layer. Comparing Table 2 and Table 3 it is seen that the drive voltage rise per nm of Alq:Li is less than half of that for Alq. The luminance, however in this series is generally low, the maximum being only 55 % of that in the thickness series of Table 2. The luminance of device 304 is 329 cd /m² which is nearly the maximum value in this thickness series. The device efficiency is 1.6 cd/A and the driving voltage is 4.3 V.

**Table 3.**

| Structure, Layer Thickness and Performance of OLED Devices with Varying Alq:Li on Fixed 5 nm Pure Alq Layer | | | | | | | | |
|---|---|---|---|---|---|---|---|---|
| Device ID | Anode ITO thickness (nm) | HIL CFx thickness (nm) | HTL NPB thickness (nm) | Pure Alq thickness (nm) | Alq :Li thickness (mn) | Cathode Mg:Ag thickness (nm) | Luminance (Cd/m²) | Drive voltage (V) |
| 301 | 42 | 1 | 150 | 5 | 25 | 110 | 233 | 3.6 |
| 302 | 42 | 1 | 150 | 5 | 35 | 110 | 281 | 4.3 |
| 303 | 42 | 1 | 150 | 5 | 45 | 110 | 321 | 4.4 |
| 304 | 42 | 1 | 150 | 5 | 55 | 110 | 329 | 4.3 |
| 305 | 42 | 1 | 150 | 5 | 65 | 110 | 319 | 4.4 |
| 306 | 42 | 1 | 150 | 5 | 75 | 110 | 304 | 5.1 |

### Example 3

In Table 4 shown are the data for a set of devices that again employ both pure Alq and Alq:Li. The thickness of the pure Alq layer was fixed at 10 nm and that of the Alq:Li. layer was varied. The performance is also plotted in FIG. 4 as a function of total Alq layer thickness. It is clearly seen that the luminance initially increases with the total Alq thickness, maximizes around 60nm, and then decreases with increasing thickness. However, in comparison with the thickness series of Table 3 the rise and fall of luminance with total Alq thickness is more rapid. The maximum luminance is 100% of that in the thickness series of Table 2. This indicates that the recombination zone extends to about 10 nm in pure Alq from the NPB/pure Alq interface. The increase in driving voltage with total Alq thickness, though again monotic, is gentler than that in the series of Table 2. The rise in drive voltage is about 30 mV per nm. The gentle slope of the voltage versus total Alq thickness plot is due to Alq:Li layer. The luminance of device 404 is 591 cd /m² which is nearly the maximum value in this thickness series. The device efficiency is 3.0 cd/A and the driving voltage is 4.7 V. It is to be noted that the same device efficiency is obtained at 6.6 V for the device 203 that used only pure Alq. The benefit of bi-layer structure consisting of pure Alq and Alq:Li is that for this series the drive voltage was decreased by nearly 2 volts while preserving the luminance.

**Table 4.**

| Structure, Layer Thickness and Performance of OLED Devices with Varying Alq:Li on Fixed 10 nm Pure Alq Layer | | | | | | | | |
|---|---|---|---|---|---|---|---|---|
| Device ID | Anode ITO thickness (nm) | HIL CFx thickness (nm) | HTL NPB thickness (nm) | Pure Alq thickness (nm) | Alq :Li thickness (nm) | Cathode Mg:Ag thickness (nm) | Luminance (Cd/m²) | Drive voltage (V) |
| 401 | 42 | 1 | 150 | 10 | 20 | 110 | 370 | 3.8 |
| 402 | 42 | 1 | 150 | 10 | 30 | 110 | 461 | 4.1 |
| 403 | 42 | 1 | 150 | 10 | 40 | 110 | 555 | 4.3 |
| 404 | 42 | 1 | 150 | 10 | 50 | 110 | 591 | 4.7 |
| 405 | 42 | 1 | 150 | 10 | 60 | 110 | 581 | 5.0 |
| 406 | 42 | 1 | 150 | 10 | 70 | 110 | 526 | 5.1 |

### Example 4

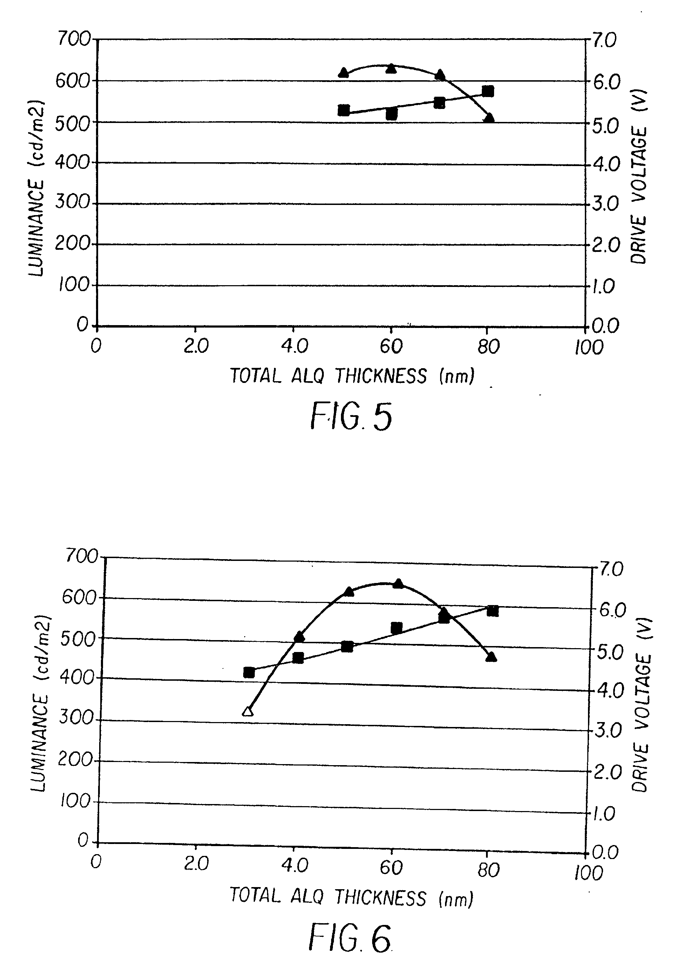

In Table 5 shown are the data for a set of devices that again employ both pure Alq and Alq:Li. The thickness of the pure Alq layer in this case was fixed at 20 nm and that of the Alq:Li layer was varied. The performance is also plotted in FIG. 5 as a function of total Alq layer thickness. It is again clearly seen that the luminance initially increases with the total Alq thickness, maximizes around 60nm, and then decreases with increasing thickness. The maximum luminance is 107% of that in the thickness series of Table 2. It may be noted that Li doping caused an enhancement of luminance in most of the devices of this series. This is unexpected in view of the finding by Kido and others that Li doping caused photoluminescence quenching. The increase in driving voltage with total Alq thickness, though again monotonic, is gentler than that in the series of Table 2. The rise in drive voltage is about 30 mV per nm. The gentle slope of the voltage versus total Alq thickness plot is due to Alq:Li layer. The luminance of the device 504 is 634 cd /m² which is nearly the maximum value in this thickness series. The device efficiency is 3.2 cd/A and the driving voltage is 5.2 V. It is to be noted that the device efficiency of 3 cd/A was obtained at 6.6 V for the device 203 that used only pure Alq. The benefit of bi-layer structure consisting of pure Alq and Alq:Li is that for this series the drive voltage was decreased by 1.4 volts while enhancing the luminance by 7%.

**Table 5.**

| Structure, Layer Thickness and Performance of OLED Devices with Varying Alq:Li on Fixed 20 nm Pure Alq Layer | | | | | | | | |
|---|---|---|---|---|---|---|---|---|
| Device ID | Anode ITO thickness (nm) | HIL CFx thickness (nm) | HTL NPB thickness (nm) | Pure Alq thickness (nm) | Alq :Li thickness (nm) | Cathode Mg:Ag thickness (nm) | Luminance (Cd/m²) | Drive voltage (V) |
| 503 | 42 | 1 | 150 | 20 | 30 | 110 | 619 | 5.3 |
| 504 | 42 | 1 | 150 | 20 | 40 | 110 | 634 | 5.2 |
| 505 | 42 | 1 | 150 | 20 | 50 | 110 | 618 | 5.5 |
| 506 | 42 | 1 | 150 | 20 | 60 | 110 | 512 | 5.8 |

### Example 5

In Table 6 shown are the data for a set of devices that again employ both pure Alq and Alq:Li. The thickness of the pure Alq layer in this case was fixed at 30 nm and that of the Alq:Li layer was varied. The performance is also plotted in FIG. 6 as a function of total Alq layer thickness. It is again clearly seen that the luminance initially increases with the total Alq thickness, maximizes around 60nm, and then decreases with increasing thickness. The maximum luminance is 109% of that in the thickness series of Table 2. It may be noted that Li doping also caused an enhancement of luminance in some of the devices of this series. This is also unexpected in view of the finding by Kido and others. The increase in driving voltage with total Alq thickness, though again monotonic, is gentler than that in the series of Table 2. The rise in drive voltage is about 30 mV per nm. The gentle slope of the voltage versus total Alq thickness plot is due to Alq:Li layer. The luminance of the device 604 is 648 cd /m² which is nearly the maximum value in this thickness series. The device efficiency is 3.2 cd/A and the driving voltage is 5.4 V. It is to be noted that the device efficiency of 3 cd/A was obtained at 6.6 V for the device 203 that used only pure Alq. The benefit of bi-layer structure consisting of pure Alq and Alq:Li is that for this series the drive voltage was decreased by 1.2 volts while enhancing the luminance by 9%.

**Table 6.**

| Structure, Layer Thickness and Performance of OLED Devices with Varying Alq:Li on Fixed 30 nm Pure Alq Layer | | | | | | | | |
|---|---|---|---|---|---|---|---|---|
| Device ID | Anode ITO thickness (nm) | HIL CFx thickness (nm) | HTL NPB thickness (nm) | Pure Alq thickness (nm) | Alq :Li thickness (nm) | Cathode Mg:Ag thickness (nm) | Luminance (Cd/m²) | Drive voltage (V) |
| 601 | 42 | 1 | 150 | 30 | 0 | 110 | 325 | 4.2 |
| 602 | 42 | 1 | 150 | 30 | 10 | 110 | 512 | 4.6 |
| 603 | 42 | 1 | 150 | 30 | 20 | 110 | 625 | 4.9 |
| 604 | 42 | 1 | 150 | 30 | 30 | 110 | 648 | 5.4 |
| 605 | 42 | 1 | 150 | 30 | 40 | 110 | 583 | 5.7 |
| 606 | 42 | 1 | 150 | 30 | 50 | 110 | 476 | 5.9 |

The data of Table 3 through Table 6 show that for all sets of devices, employing both pure Alq and Alq:Li layers, and each set using a different fixed thickness of pure Alq layer, the luminance was maximized when the total Alq layer thickness attained about 60 nm. As seen in Table 2 that for the pure Alq devices too the luminance was maximized at the pure Alq tayer thickness of about 60 nm. However, the benefit of splitting the active layer into pure Alq and Alq:Li layers is that the drive voltage is substantially reduced while enhancing or preserving the luminance.

### Example 6

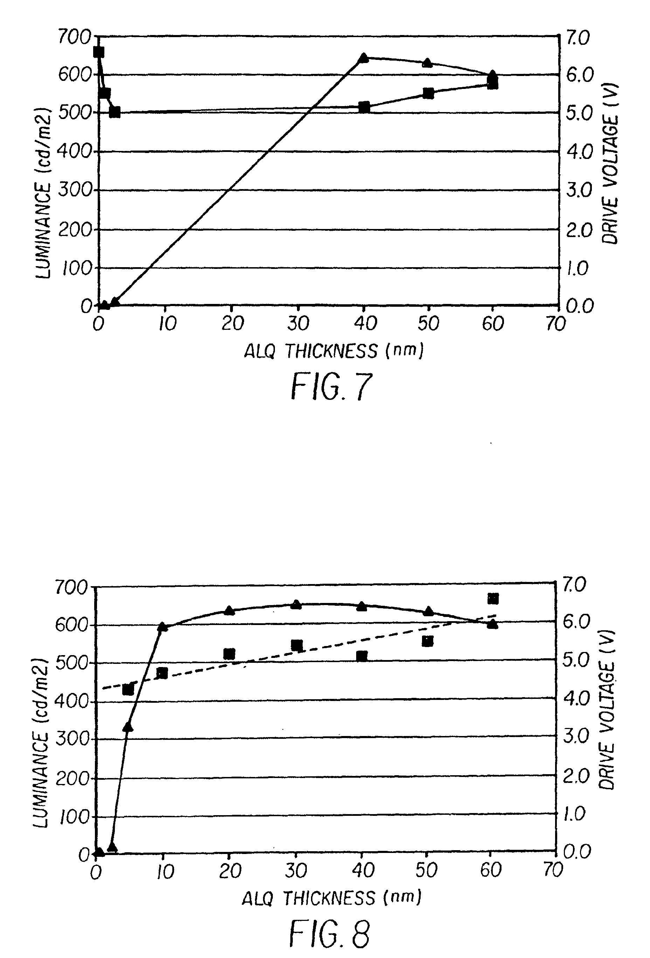

Table7 show the data for a set of devices that contain both pure Alq and Alq:Li layers such that for each of the devices the total total Alq thickness is 60nm. The device performance is also plotted in FIG. 7 as a function of thicknesses of the pure Alq layer. The devices 701 having no pure Alq layer and devices 702 and 703 containing ultrathin layers of pure Alq have negligible luminance. The recombination zone for these devices is believed to lie almost completely in Alq:Li region that is non-emitting. The luminance is severely quenched due to Li mixing of pure Alq. The measurements of drive voltages for these extremely low-efficiency cells are found unreliable. The emitting zones for devices 704 and 705 lie in pure Alq, and the devices yield high luminance.

**Table 7.**

| Structure, Layer Thickness and Performance of OLED Devices with Varying Alq and Alq:Li Layers (Total Alq Layer thickness fixed at 60 nm) | | | | | | | | |
|---|---|---|---|---|---|---|---|---|
| Device ID | Anode ITO thickness (nm) | HIL CFx thickness (nm) | HTL NPB thickness (nm) | Pure Alq thickness (nm) | Alq :Li thickness (nm) | Cathode Mg:Ag thickness (nm) | Luminance (Cd/m²) | Drive voltage (V) |
| 701 | 42 | 1 | 150 | 0 | 69 | 110 | 0 | 6.6 |
| 702 | 42 | 1 | 150 | 1 | 59 | 110 | 2 | 5.5 |
| 703 | 42 | 1 | 150 | 2.5 | 57.5 | 110 | 13 | 5.0 |
| 704 | 42 | 1 | 150 | 40 | 20 | 110 | 642 | 5.1 |
| 705 | 42 | 1 | 150 | 50 | 10 | 110 | 629 | 5.5 |
| 706 | 42 | 1 | 150 | 60 | 0 | 110 | 598 | 5.7 |

### Example 7

In Table 8 compiled are the structures and performances of a single-layer device of pure Alq, a single-layer device of Alq:Li along with several bi-layer devices comprising pure Alq and Alq:Li layers. These devices are selected from Table 2 through Table 7 such that the total Alq thickness for each of the devices is 60 nm. The performance of these devices as a function of pure Alq layer thickness is plotted in FIG. 8. It is seen that when the pure Alq layer is almost completely or completely mixed with Li leaving only an ultrathin or no pure Alq layer, the luminance is insignificantly small. The luminance, however, rapidly rises with the pure Alq layer thickness reaching its maximum value at around 30 nm. The drive voltage rise with increasing pure Alq layer thickness is monotonic but gradual. It is to be noted that at only 10 nm pure Alq layer thickness the luminance is 92% of the maximum value. This indicates that the recombination of charge carriers that results in emission is taking place almost entirely within this zone of pure Alq. The recombination zone, or more accurately the exciton emission zone, in pure Alq extends to about 10 nm from the NPB/pure Alq interface. It is to be noted that even with the 5 nm of pure Alq layer the luminance is appreciable. The luminance still increases rapidly with the pure Alq thickness upto about 10 nm, but beyond 10 nm the rise in luminance is gradual and falls gently after 30 nm. It is also clear that the pure Alq layer can be about 40 nm thick without seriously degrading the operating voltage. With thin pure Alq layer the thickness of Alq:Li should be greater than 0 and less than 70 nm to have high luminance and low voltage. Acceptable devices can be made when total Alq thickness ranges from 30 to 100 nm. However, optimally designed devices should have a total Alq thickness in the range of 50 to 90 nm and more preferably in the range of 60 to 70 nm.

**Table 7.**

| Structure, Layer Thickness and Performance of OLED Devices with Varying Alq and Alq:Li Layers (Total Alq Layer thickness fixed at 60 nm) | | | | | | | | |
|---|---|---|---|---|---|---|---|---|
| Device ID | Anode ITO thickness (nm) | HIL CFx thickness (nm) | HTL NPB thickness (nm) | Pure Alq thickness (nm) | Alq :Li thickness (nm) | Cathode Mg:Ag thickness (nm) | Luminance (Cd/m²) | Drive voltage (V) |
| 701 | 42 | 1 | 150 | 0 | 69 | 110 | 0 | |
| 702 | 42 | 1 | 150 | 1 | 59 | 110 | 2 | |
| 703 | 42 | 1 | 150 | 2.5 | 57.5 | 110 | 13 | |
| 304 | 42 | 1 | 150 | 5 | 55 | 110 | 329 | 4.3 |
| 404 | 42 | 1 | 150 | 10 | 50 | 110 | 591 | 4.7 |
| 504 | 42 | 1 | 150 | 20 | 40 | 110 | 634 | 5.2 |
| 604 | 42 | 1 | 150 | 30 | 30 | 110 | 648 | 5.4 |
| 704 | 42 | 1 | 150 | 40 | 20 | 110 | 642 | 5.1 |
| 705 | 42 | 1 | 150 | 50 | 10 | 110 | 629 | 5.5 |
| 203 | 42 | 1 | 150 | 60 | 0 | 110 | 592 | 6.6 |

Furthermore, unexpectedly, the bi-layer devices 504 (Table 5), 604 (Table 6), 704 (Table 7) are all found to have luminances higher than that of the single-layer pure Alq device 203 (Table 2). There appears to be an enhancement of luminance in these bilayer devices. It is also seen that the device 404 (Table 4) that has a 10 nm thick pure Alq layer backed with a 50 nm thick Alq:Li layer has the same luminance as that of the device 203 - a single-layer device of 60 nm thick pure Alq. But the bi-layer device achieved this luminance at a reduced drive voltage. The reduction in drive voltage realized in this example is about 2 volts.

### Example 8

One device of the present invention having a 15 nm Alq:Li layer was tested for operational stability. At the end of about 300 hr the device retained about 94% of the initial luminance with no decernible change in the operating voltage. Upon continuing the test for another 100 hr the efficiency further dropped by 2% but the operating voltage stayed same.

Table 3 through Table 8 and FIG. 3 through FIG. 8 show the benefit of spatially modifying the Alq layer. Splitting the Alq layer into a pure and lithium mixed sublayers of Alq referred to as a bi-layer the device can enhance performance. The optimally designed bi-layer structure yields devices with reduced drive voltage while enhancing the luminescence efficiency.

Other features of the invention are included below.

The OLED device wherein the emissive layer contains one or more light emitting doped materials.

## Claims

1. An OLED device, comprising:
a) a substrate;
b) an anode formed of a conductive material over the substrate;
c) an emissive layer having an electroluminescent material provided over the anode layer;
d) an electron -transport layer provided over the emissive layer and containing Li metal; and
e) a cathode layer provided on the electron transport layer such cathode layer being formed of a material which can work as an efficient electron injecting contact without the modification of electron transport layer and having a work function function between about 2.0 and about 4.0 V.

2. An OLED device, comprising:
a) a substrate;
b) an anode formed of a conductive material over the substrate;
c) a hole injection layer provided over the anode layer;
d) a hole transport layer provided over the hole injection layer;
e) an emissive layer having an electroluminescent material provided over the hole transport layer;
(f) an electron transport layer provided over the emissive layer and containing Li metal; and
(g) a cathode layer provided on the electron transport layer such cathode layer being formed of a material which can work as an efficient electron injecting contact without the modification of electron transport layer and having a work function between about 2.0 and about 4.0 V.

3. The OLED device of claim 1 wherein the Li metal concentration is between 1 to 5 % by volume.

4. The OLED device of claim 4 wherein the emissive layer has a thickness greater than 5 and less than 40 nm.

5. The OLED device of claim 1 wherein the electron transport Alq:Li layer has a thickness greater than 0 and less than 70 nm.

6. The OLED device of claim 1 wherein the emissive and the electron transport layers have a combined thickness in the range of 30 to 100nm.

7. The OLED device of claim 6 wherein the emissive and the electron transport layer has a combined thickness in the range of 50 to 90 nm.

8. The OLED device of claim 6 wherein the emissive and the electron transport layer has a combined thickness in the range of 60 to 70 nm.

9. The OLED device of claim 1 wherein the layer includes Alq.

10. A method of making an OLED device, comprising the steps of:
a) providing a substrate;
b) forming an anode of a conductive material over the substrate;
c) depositing an emissive layer having an electroluminescent material provided over the anode;
d) depositing an electron transport layer by coevaporation of an electron-transport material and Li metal on the emissive layer; and
e) depositing a cathode layer on the electron transport layer.
